# EUROPEAN PATENT APPLICATION

(11) **EP 4 474 940 A1**
(43) Date of publication of application: **11.12.2024**
(21) Application number: 24718312.2
(22) Date of filing: 16.04.2024
(51) Int. Cl.: G06F 1/00

(54) **ELECTRONIC DEVICE COMPRISING HEAT DISSIPATION STRUCTURE**

(30) Priority: 17.04.2023 KR 20230050355; 28.08.2023 KR 20230113078
(71) Applicant: Samsung Electronics Co., Ltd., Suwon-si, Gyeonggi-do 16677 (KR)
(72) Inventor: LIM, Jonghyun, Suwon-si Gyeonggi-do 16677 (KR); PARK, Jongkil, Suwon-si Gyeonggi-do 16677 (KR); KIM, Jihong, Suwon-si Gyeonggi-do 16677 (KR); MOON, Hongki, Suwon-si Gyeonggi-do 16677 (KR)
(74) Representative: Nederlandsch Octrooibureau
(86) International application number: PCT/KR2024/005086
(87) International publication number: WO 2024/219790

(57) **Abstract**

An electronic device according to an embodiment includes a vapor chamber including a first plate, a second plate supporting the first plate, and a wick structure between the first plate and the second plate. The first plate includes a first region including a heat dissipation portion, and a second region connected to the first region. The wick structure includes a first wick including a first portion covering one surface of the first region, and a second portion extending from the first portion along the second region, and a second wick extending from the second plate to the second portion.

## Description

### [Technical Field]

Various embodiments described later relate to an electronic device including a heat dissipation structure.

### [Background Art]

An electronic device may include various electronic components to meet user's needs. The electronic device may be miniaturized so that it may be worn by a user or carried by the user. As electronic components disposed within the electronic device perform operations to respond to a user's request, heat may be generated within the miniaturized electronic device. The electronic device may include a structure for dispersing heat within the electronic device.

The above-described information may be provided as a related art for the purpose of aiding understanding of the present disclosure. No argument or decision has been made as to whether any of the above-described contents may be applied as a prior art related to the present disclosure.

### [Disclosure]

### [Technical Solution]

An electronic device according to an embodiment may comprise an electronic component. The electronic device may comprise a vapor chamber including a first plate, a second plate supporting the first plate, and a wick structure between the first plate and the second plate. The first plate may include a first region on which the electronic component is disposed, and a second region connected to the first region. The wick structure may include a first wick including a first portion covering one surface of the first region facing the second plate, and a second portion extending from the first portion along the second region. The wick structure may include a second wick extending from the second plate to the second portion.

An electronic device according to an embodiment may comprise an electronic component. The electronic device according to an embodiment may comprise a vapor chamber configured to receive at least a portion of heat emitted from the electronic component, and including a first plate, a second plate supporting the first plate, and a wick structure between the first plate and the second plate. The first plate may include a first region including a heat dissipation portion facing the electronic component, and a second region connected to the first region. The wick structure may include a first wick including a first portion covering one surface of the first region facing the second plate, and a second portion extending from the first portion along the second region and including first flow paths spaced apart from each other. The wick structure may include a second wick extending from the second plate to the second portion and including a second flow paths contacting the first flow paths, respectively. A width of the first portion may be greater than a width of the second portion.

### [Description of the Drawings]

FIG. 1 is a block diagram of an electronic device in a network environment according to an embodiment.
FIG. 2 is a diagram illustrating an electronic device according to an embodiment.
FIG. 3 is an exploded perspective view of an electronic device according to an embodiment.
FIG. 4A is an exploded perspective view of a vaper chamber of an exemplary electronic device.
FIG. 4B is a top plan view of a vaper chamber of an exemplary electronic device.
FIG. 5A is a cross-sectional view of an exemplary vaper chamber cut along line A-A' of FIG. 4B.
FIG. 5B is a cross-sectional view of an exemplary vaper chamber cut along line B-B' of FIG. 4B.
FIG. 5C is a cross-sectional view of an exemplary vaper chamber cut along line C-C' of FIG. 4B.
FIG. 6 is an exploded perspective view of a vaper chamber of an exemplary electronic device.
FIG. 7A illustrates a vaper chamber of an exemplary electronic device.
FIG. 7B is an exploded perspective view of a vaper chamber of the exemplary electronic device of FIG. 7A.
FIGS. 8A and 8B illustrate a manufacturing process of a second plate of an exemplary vaper chamber.

### [Mode for Invention]

Hereinafter, embodiments of the present disclosure will be described in detail with reference to the drawings so that those having ordinary knowledge in the technical field to which the present disclosure pertains may easily implement it. However, the present disclosure may be implemented in a number of different forms and is not limited to the embodiments described herein. In relation to the description of the drawings, the same or similar reference numerals may be used for the same or similar components. In addition, in drawings and related descriptions, descriptions of well-known functions and configurations may be omitted for clarity and brevity.

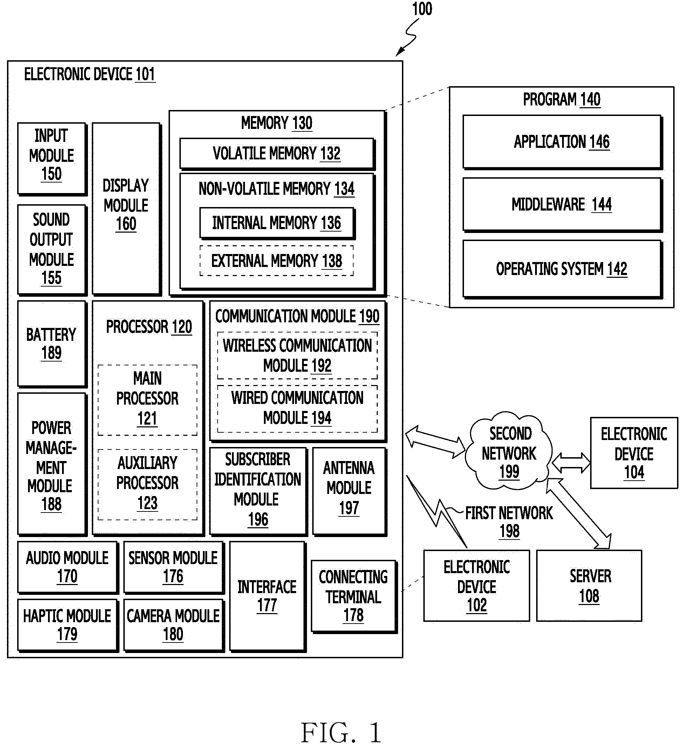

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

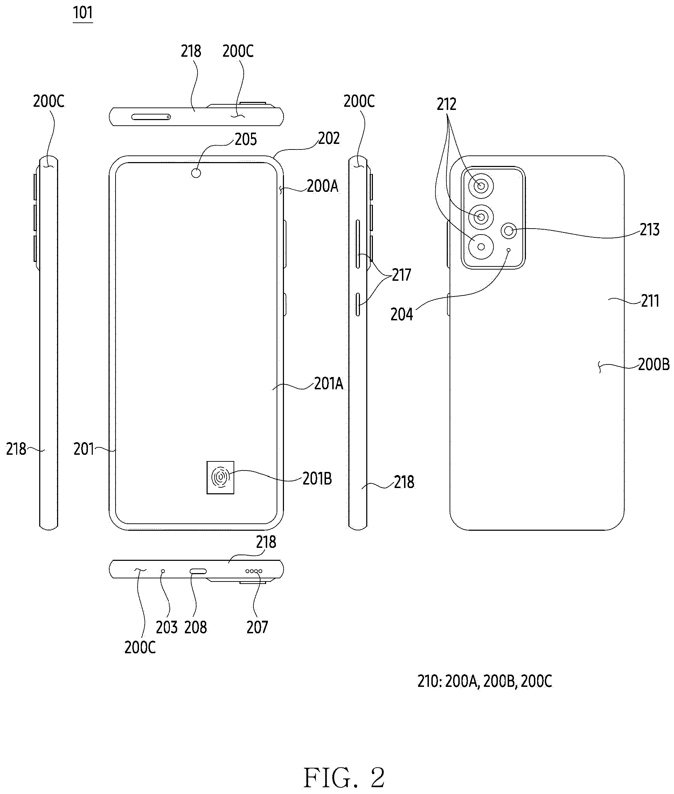

FIG. 2 is a diagram illustrating an electronic device according to an embodiment.

Referring to FIG. 2, an electronic device 101 according to an embodiment may include a housing 210 forming an exterior of the electronic device 101. For example, the housing 210 may include a front surface 200A, a rear surface 200B, and a side surface 200C surrounding a space between the front surface 200A and the rear surface 200B. According to an embodiment, the housing 210 may refer to a structure forming at least a portion of the front surface 200A, the rear surface 200B, and/or the side surface 200C.

The electronic device 101 according to an embodiment may include a substantially transparent front plate 202. According to an embodiment, the front plate 202 may form at least a portion of the front surface 200A. According to an embodiment, the front plate 202 may include, for example, a glass plate including various coating layers or a polymer plate, but the disclosure is not limited thereto.

The electronic device 101 according to an embodiment may include a substantially opaque rear plate 211. According to an embodiment, the rear plate 211 may form at least a portion of the rear surface 200B. According to an embodiment, the rear plate 211 may be formed of coated or colored glass, ceramic, polymer, metal (e.g., aluminum, stainless steel (STS), or magnesium), or a combination of at least two of the above materials.

The electronic device 101 according to an embodiment may include a side structure (or side member) 218. According to an embodiment, the side structure 218 may be coupled to the front plate 202 and/or the rear plate 211 to form at least a portion of the side surface 200C of the electronic device 101. For example, the side structure 218 may form all of the side surface 200C of the electronic device 101, and for another example, the side structure 218 may form the side surface 200C of the electronic device 101 together with the front plate 202 and/or the rear plate 211.

Unlike the illustrated embodiment, in the case that the side surface 200C of the electronic device 101 is partially formed by the front plate 202 and/or the rear plate 211, the front plate 202 and/or the rear plate 211 may include a region that is bent from its periphery toward the rear plate 211 and/or the front plate 202 and seamlessly extends. The extended region of the front plate 202 and/or the rear plate 211 may be positioned at both ends of, for example, a long edge of the electronic device 101, but the disclosure is not limited to the above-described examples.

According to an embodiment, the side structure 218 may include a metal and/or a polymer. According to an embodiment, the rear plate 211 and the side structure 218 may be integrally formed and may include the same material (e.g., a metal material such as aluminum), but the disclosure are not limited thereto. For example, the rear plate 211 and the side structure 218 may be formed in separate configurations and/or may include different materials.

According to an embodiment, the electronic device 101 may include at least one of a display 201, an audio module 203, 204 and 207, a sensor module (not shown), a camera module 205, 212, 213, a key input device 217, a light emitting device (not shown), and/or a connector hole 208. According to another embodiment, the electronic device 101 may omit at least one of the components (e.g., a key input device 217 or a light emitting device (not shown)), or may further include another component.

According to an embodiment, the display 201 may be visually exposed through a substantial portion of the front plate 202. For example, at least a portion of the display 201 may be visible through the front plate 202 forming the front surface 200A. According to an embodiment, the display 201 may be disposed on the second surface of the front plate 202.

According to an embodiment, the appearance of the display 201 may be formed substantially the same as the appearance of the front plate 202 adjacent to the display 201. According to an embodiment, in order to expand the area in which the display 201 is visually exposed, the distance between the outside of the display 201 and the outside of the front plate 202 may be formed to be generally the same.

According to an embodiment, the display 201 (or the front surface 200A of the electronic device 101) may include a screen display area 201A. According to an embodiment, the display 201 may provide visual information to a user through the screen display area 201A. In the illustrated embodiment, when the front surface 200A is viewed from the front, it is illustrated that the screen display area 201A is spaced apart from the outside of the front surface 200A and is positioned inside the front surface 200A, but the disclosure is not limited thereto. In another embodiment, when the front surface 200A is viewed from the front, at least a portion of the periphery of the screen display area 201A may substantially coincide with the periphery of the front surface 200A (or the front plate 202).

According to an embodiment, the screen display area 201A may include a sensing area 201B configured to obtain biometric information of a user. Here, the meaning of "the screen display area 201A including the sensing area 201B" may be understood to mean that at least a portion of the sensing area 201B may be overlapped on the screen display area 201A. For example, the sensing area 201B, like other areas of the screen display area 201A, may refer to an area in which visual information may be displayed by the display 201 and additionally biometric information (e.g., fingerprint) of a user may be obtained. In another embodiment, the sensing area 201B may be formed in the key input device 217.

According to an embodiment, the display 201 may include an area in which the first camera module 205 is positioned. According to an embodiment, an opening may be formed in the area of the display 201, and the first camera module 205 (e.g., a punch hole camera) may be at least partially disposed in the opening to face the front surface 200A. In such a case, the screen display area 201A may surround at least a portion of the periphery of the opening. According to an embodiment, the first camera module 205 (e.g., an under display camera (UDC)) may be disposed under the display 201 to overlap the area of the display 201. In this case, the display 201 may provide visual information to the user through the area, and additionally, the first camera module 205 may obtain an image corresponding to a direction facing the front surface 200A through the area of the display 201.

According to an embodiment, the display 201 may be coupled to or disposed adjacent to a touch sensing circuit, a pressure sensor capable of measuring the intensity (pressure) of the touch, and/or a digitizer that detects a magnetic field type stylus pen.

According to an embodiment, the audio modules 203, 204 and 207 may include microphone holes 203 and 204, and a speaker hole 207.

According to an embodiment, the microphone holes 203 and 204 may include a first microphone hole 203 formed in a partial area of the side surface 200C and a second microphone hole 204 formed in a partial area of the rear surface 200B. A microphone (not shown) for obtaining an external sound may be disposed inside the microphone holes 203 and 204. The microphone may include a plurality of microphones to detect the direction of sound.

According to an embodiment, the second microphone hole 204 formed in a partial area of the rear surface 200B may be disposed adjacent to the camera modules 205, 212 and 213. For example, the second microphone hole 204 may obtain sound according to operations of the camera modules 205, 212, and 213. However, the disclosure is not limited thereto.

According to an embodiment, the speaker hole 207 may include an external speaker hole 207 and a receiver hole (not illustrated) for a call. The external speaker hole 207 may be formed on a portion of the side surface 200C of the electronic device 101. According to an embodiment, the external speaker hole 207 may be implemented as a single hole together with the microphone hole 203. Although not illustrated, a receiver hole (not shown) for a call may be formed on another portion of the side surface 200C. For example, the receiver hole for a call may be formed on the opposite side of the external speaker hole 207 on the side surface 200C. For example, with respect to the illustration of FIG. 2, the external speaker hole 207 may be formed on the side surface 200C corresponding to the lower end of the electronic device 101, and the receiver hole for a call may be formed on the side surface 200C corresponding to the upper end of the electronic device 101. However, the disclosure is not limited thereto, and according to an embodiment, the receiver hole for a call may be formed at a position other than the side surface 200C. For example, the receiver hole for a call may be formed by a space spaced apart between the front plate 202 (or display 201) and the side bezel structure 218.

According to an embodiment, the electronic device 101 may include at least one speaker (not illustrated) configured to output sound to the outside of the housing 210 through an external speaker hole 207 and/or a receiver hole (not shown) for a call.

According to an embodiment, the sensor module (not shown) may generate an electrical signal or data value corresponding to an internal operating state or an external environmental state of the electronic device 101. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, and an illumination sensor.

According to an embodiment, the camera modules 205, 212 and 213 may include a first camera module 205 disposed to face the front surface 200A of the electronic device 101, a second camera module 212 disposed to face the rear surface 200B, and a flash 213.

According to an embodiment, the second camera module 212 may include a plurality of cameras (e.g., a dual camera, a triple camera, or a quad camera). However, the second camera module 212 is not necessarily limited to including a plurality of cameras, and may include one camera.

According to an embodiment, the first camera module 205 and the second camera module 212 may include one or a plurality of lenses, an image sensor, and/or an image signal processor.

According to an embodiment, the flash 213 may include, for example, a light emitting diode or a xenon lamp. According to an embodiment, two or more lenses (infrared camera, wide-angle and telephoto lens) and image sensors may be disposed on one side of the electronic device 101.

According to an embodiment, the key input device 217 (e.g., an input module 150 of FIG. 1) may be disposed on the side surface 200C of the electronic device 101. According to an embodiment, the electronic device 101 may not include some or all of the key input devices 217, and the key input device 217 not included therein may be implemented on the display 201 in another form such as a soft key.

According to an embodiment, the connector hole 208 may be formed on the side surface 200C of the electronic device 101 to accommodate the connector of the external device. A connection terminal electrically connected to the connector of the external device may be disposed in the connector hole 208. The electronic device 101 according to an embodiment may include an interface module for processing electrical signals transmitted and received through the connection terminal.

According to an embodiment, the electronic device 101 may include a light emitting device (not shown). For example, the light emitting device (not shown) may be disposed on the front surface 200A of the housing 210. The light emitting device (not shown) may provide state information of the electronic device 101 in a form of light. In another embodiment, the light emitting device (not shown) may provide a light source when the first camera module 205 is operated. For example, the light emitting device (not shown) may include an LED, an IR LED, and/or a xenon lamp.

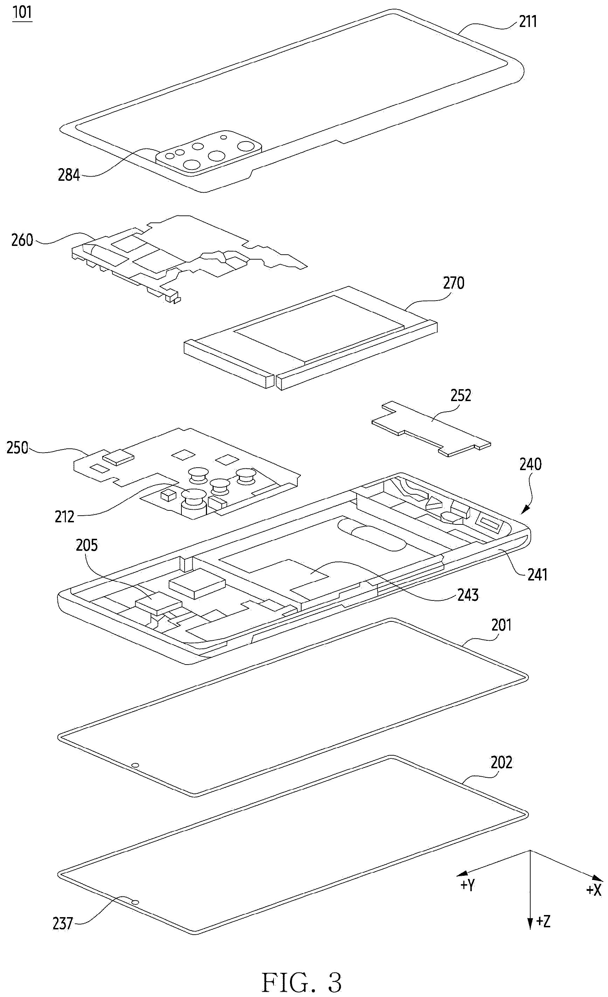

FIG. 3 is an exploded perspective view of an electronic device according to an embodiment.

Hereinafter, overlapping descriptions of components having the same reference numerals as those of the above-described components will be omitted.

Referring to FIG. 3, the electronic device 101 according to an embodiment may include a frame structure 240, a first printed circuit board 250, a second printed circuit board 252, a cover plate 260, and a battery 270.

According to an embodiment, the frame structure 240 may include a sidewall 241 forming an exterior (e.g., the third surface 200C of FIG. 2) of the electronic device 101 and a support portion 243 extending inward from the sidewall 241. According to an embodiment, the frame structure 240 may be disposed between the display 201 and the rear plate 211. According to an embodiment, the sidewall 241 of the frame structure 240 may surround a space between the rear plate 211 and the front plate 202 (and/or the display 201), and the support portion 243 of the frame structure 240 may extend from the sidewall 241 within the space.

According to an embodiment, the frame structure 240 may support or accommodate other components included in the electronic device 101. For example, the display 201 may be disposed on one surface of the frame structure 240 facing one direction (e.g., the +z direction), and the display 201 may be supported by the support portion 243 of the frame structure 240. For another example, a first printed circuit board 250, a second printed circuit board 252, a battery 270, and a rear camera 212 may be disposed on the other surface facing a direction opposite to the one direction (e.g., the -z direction) of the frame structure 240. The first printed circuit board 250, the second printed circuit board 252, the battery 270, and the rear camera 212 may be mounted on a recess defined by the sidewall 241 and/or the support portion 243 of the frame structure 240.

According to an embodiment, the first printed circuit board 250, the second printed circuit board 252, and the battery 270 may be coupled to the frame structure 240, respectively. For example, the first printed circuit board 250 and the second printed circuit board 252 may be fixedly disposed in the frame structure 240 through a coupling member such as a screw. For example, the battery 270 may be fixedly disposed on the frame structure 240 through an adhesive member (e.g., a double-sided tape). However, it is not limited by the above-described example.

According to an embodiment, a cover plate 260 may be disposed between the first printed circuit board 250 and the rear plate 211. According to an embodiment, the cover plate 260 may be disposed on the first printed circuit board 250. For example, the cover plate 260 may be disposed on a surface facing the -z direction of the first printed circuit board 250.

According to an embodiment, the cover plate 260 may at least partially overlap the first printed circuit board 250 with respect to the z-axis. According to an embodiment, the cover plate 260 may cover at least a partial area of the first printed circuit board 250. Through this, the cover plate 260 may protect the first printed circuit board 250 from physical impact or prevent the connector coupled to the first printed circuit board 250 from being separated.

According to an embodiment, the cover plate 260 may be fixedly disposed on the first printed circuit board 250 through a coupling member (e.g., a screw), or may be coupled to the frame structure 240 together with the first printed circuit board 250 through the coupling member.

According to an embodiment, the display 201 may be disposed between the frame structure 240 and the front plate 202. For example, a front plate 202 may be disposed on one side (e.g., a +z direction) of the display 201 and a frame structure 240 may be disposed on the other side (e.g., a -z direction).

According to an embodiment, the front plate 202 may be coupled to the display 201. For example, the front plate 202 and the display 201 may adhere to each other through an optical adhesive member (e.g., optically clear adhesive (OCA) or optically clear resin (OCR)) interposed therebetween.

According to an embodiment, the front plate 202 may be coupled to the frame structure 240. For example, the front plate 202 may include an outside portion extending outside the display 201 when viewed in the z-axis direction, and may adhere to the frame structure 240 through an adhesive member (e.g., a double-sided tape) disposed between the outside portion of the front plate 202 and the frame structure 240 (e.g., the sidewall 241). However, it is not limited by the above-described example.

According to an embodiment, the first printed circuit board 250 and/or the second printed circuit board 252 may be equipped with a processor (e.g., a processor 120 of FIG. 1), a memory (e.g., a memory 130 of FIG. 1), and/or an interface (e.g., an interface 177 of FIG. 1). The processor may include, for example, one or more of a central processing unit, an application processor, a graphic processing unit, an image signal processor, a sensor hub processor, or a communication processor. The memory may include, for example, a volatile memory or a nonvolatile memory. The interface may include, for example, a high definition multimedia interface (HDMI), a universal serial bus (USB) interface, an SD card interface, and/or an audio interface. The interface may electrically or physically connect the electronic device 101 to an external electronic device, and may include a USB connector, an SD card/MMC connector, or an audio connector. According to an embodiment, the first printed circuit board 250 and the second printed circuit board 252 may be operatively or electrically connected to each other through a connection member (e.g., a flexible printed circuit board).

According to an embodiment, the battery 270 may supply power to at least one component of the electronic device 101. For example, the battery 270 may include a rechargeable secondary cell or a fuel cell. At least a portion of the battery 270 may be disposed on substantially the same plane as the first printed circuit board 250 and/or the second printed circuit board 252.

The electronic device 101 according to an embodiment may include an antenna module (not illustrated) (e.g., an antenna module 197 of FIG. 1). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module, for example, may perform short-range communication with an external device, or wirelessly transmit and receive power to and from the external device.

According to an embodiment, the front camera 205 may be disposed in at least a portion (e.g., a support portion 243) of the frame structure 240 so that the lens may receive external light through a partial area (e.g., a camera area 237) of the front plate 202.

According to an embodiment, the rear camera 212 may be disposed between the frame structure 240 and the rear plate 211. According to an embodiment, the rear camera 212 may be electrically connected to the first printed circuit board 250 through a connection member (e.g., a connector). According to an embodiment, the rear camera 212 may be disposed such that the lens may receive external light through a camera area 284 of the rear plate 211 of the electronic device 101.

According to an embodiment, the camera area 284 may be formed on the surface (e.g., a rear surface 200B of FIG. 2) of the rear plate 211. According to an embodiment, the camera area 284 may be formed to be at least partially transparent so that external light may be incident to the lens of the rear camera 212. According to an embodiment, at least a portion of the camera area 284 may protrude from the surface of the rear plate 211 to a predetermined height. However, it is not limited to thereto, and in another embodiment, the camera area 284 may form a plane substantially the same as the surface of the rear plate 211.

According to an embodiment, the housing(e.g., a housing 210 of FIG. 2) of the electronic device 101 may mean a configuration or structure forming at least a portion of the exterior of the electronic device 101. In this regard, at least a portion of the front plate 202, the frame structure 240, and/or the rear plate 211 forming the exterior of the electronic device 101 may be referred to as the housing 210 of the electronic device 101.

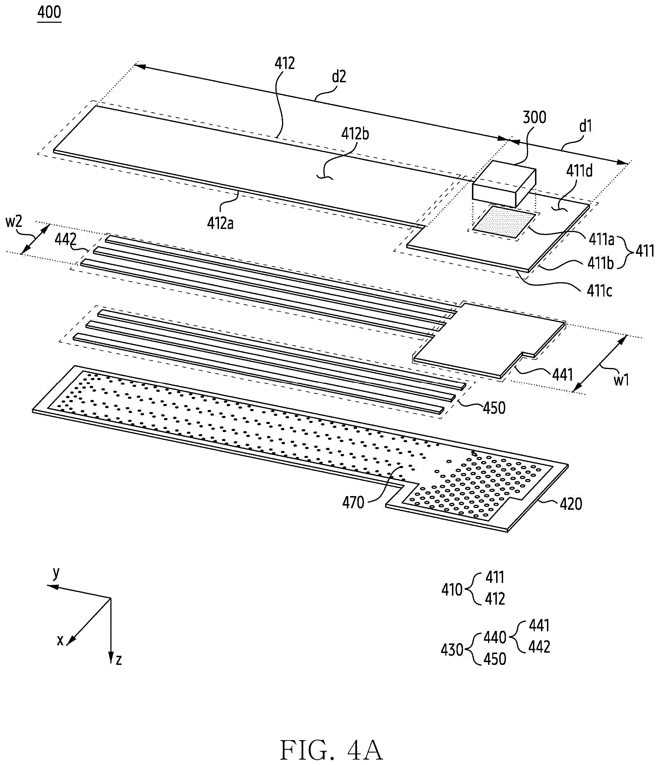

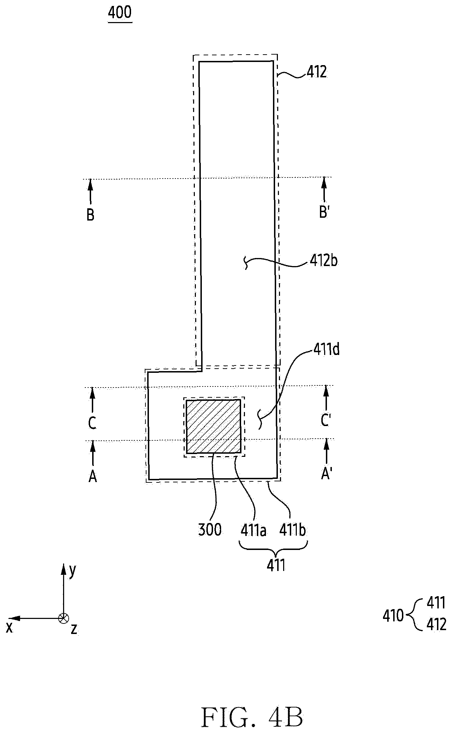

FIG. 4A is an exploded perspective view of a vaper chamber of an exemplary electronic device. FIG. 4B is a top plan view of a vaper chamber of an exemplary electronic device.

Referring to FIGS. 4A and 4B, an electronic device (e.g., an electronic device 101 of FIG. 1) may include an electronic component 300 and a vapor chamber 400.

According to an embodiment, the vapor chamber 400 may be configured to receive at least a portion of the heat emitted from the electronic component 300. For example, the vapor chamber 400 may be disposed within the electronic device 101. The vapor chamber 400 may be disposed around the electronic component 300 to receive heat emitted from the electronic component 300. For example, at least a portion of the vapor chamber 400 may at least partially overlap the electronic component 300 when the electronic component 300 is viewed from above (e.g., when viewed in the +z direction). For example, at least a portion of the vapor chamber 400 may face the electronic component 300. For example, at least a portion of the vapor chamber 400 may be in contact with the electronic component 300.

For example, the electronic component 300 may be mounted on a printed circuit board (e.g., a first printed circuit board 250 or a second printed circuit board 252 of FIG. 3) within the electronic device 101. At least a portion of the vapor chamber 400 may face at least a portion of the printed circuit board on which the electronic component 300 is disposed. For example, the vapor chamber 400 may be seated on a structure (e.g., a supporting structure 243 of FIG. 3) within the electronic device 101 facing the printed circuit board, in order to receive at least a portion of the heat generated from the electronic component 300 disposed on the printed circuit board (e.g., the first printed circuit board 250 or the second printed circuit board 252). For example, at least a portion (e.g., a frame structure 240 of FIG. 3) of a housing (e.g., a housing 210 of FIG. 2) of the electronic device 101 may be disposed between the electronic component 300 and the vapor chamber 400. The vapor chamber 400 may be configured to receive at least a portion of the heat generated from the electronic component 300 through at least a portion of the housing. At least a portion of the housing disposed between the electronic component 300 and the vapor chamber 400 may include metal, but is not limited thereto.

For example, the electronic component 300 may be a processor (e.g., a processor 120 of FIG. 1) of the electronic device 101 having a relatively large amount of heat generated. For example, the electronic component 300 may be disposed on one surface of the printed circuit board (e.g., the first printed circuit board 250 or the second printed circuit board 252 of FIG. 3) facing the vaper chamber 400. The electronic component 300 may perform data processing or calculation as the electronic device 101 operates. The electronic component 300 may emit the heat as data processing or calculation is performed. The vapor chamber 400 may reduce damage to the electronic component 300 and/or at least one other electronic component around the electronic component 300 by the heat, by receiving at least a portion of the heat emitted from the electronic component 300.

According to an embodiment, the vapor chamber 400 may include a first plate 410, a second plate 420 supporting the first plate, and a wick structure 430 between the first plate 410 and the second plate 420.

For example, the first plate 410 may include a portion facing the electronic component 300 configured to emit the heat. For example, the first plate 410 may be a portion of the vaper chamber 400 that receives the heat from the electronic component 300. For example, the first plate 410 may support the electronic component 300. For example, the first plate 410 may be in contact with the electronic component 300. For example, the first plate 410 may include metal to diffuse heat received from the electronic component 300, but is not limited thereto.

For example, the second plate 420 may face the first plate 410. For example, at least a portion of the second plate 420 may be attached to the first plate 410. For example, the second plate 420, together with the first plate 410, may cover the space between the first plate 410 and the second plate 420. For example, the second plate 420 may receive at least a portion of the heat transferred from the electronic component 300 to the first plate 410. For example, the second plate 420 may include a plurality of pillars 470 extending from the second plate 420 toward the first plate 410, to support the first plate 410. For example, the second plate 420 may provide a seating space for the wick structure 430.

For example, the wick structure 430 may be disposed within a space covered by the first plate 410 and the second plate 420. For example, the wick structure 430 may be supported by the second plate 420. For example, the wick structure 430 may be in contact with the first plate 410 and the second plate 420 within the space covered by the first plate 410 and the second plate 420. For example, at least a portion of the heat transferred from the electronic component 300 to the first plate 410 may be transferred to the wick structure 430 in contact with the first plate 410. The wick structure 430 may be referred to as a porous material for moving fluid within the vapor chamber 400, but is not limited thereto.

According to an embodiment, the first plate 410 may include a first region 411 on which the electronic component 300 is disposed, and a second region 412 connected to the first region 411. The first region 411 may include a heat dissipation portion 411a facing the electronic component 300. For example, the heat dissipation portion 411a may be a portion of the first plate 410 that receives the heat from the electronic component 300. For example, the heat dissipation portion 411a may be a portion that overlaps the electronic component 300 when the first plate 410 is viewed from above (e.g., when viewed in the -z direction). For example, the heat dissipation portion 411a may be referred to as a heat source of the vapor chamber 400 in terms of a portion that receives the heat from the electronic component 300, but is not limited thereto. For example, the second region 412 may extend from the first region 411 including the heat dissipation portion 411a. For example, the second region 412 may have a length in the +y direction from the portion in contact with the first region 411.

According to an embodiment, the first region 411 may further include a third region 411b that surrounds the heat dissipation portion 411a and is in contact with the second region 412. For example, the third region 411b may extend from the heat dissipation portion 411a to the second region 412. For example, the third region 411b may be a region of the first region 411 for diffusing the heat transferred from the electronic component 300 to the heat dissipation portion 411a. For example, the third region 411b may transfer at least a portion of the heat transferred to the heat dissipation portion 411a to the second region 412, by connecting the heat dissipation portion 411a and the second region 412. The first region 411 may be configured to diffuse heat transferred from the electronic component 300 to the first plate 410 within the first region 411, by including the heat dissipation portion 411a and the third region 411b surrounding the heat dissipation portion 411a.

According to an embodiment, the first region 411 may include a first surface 411c facing the second plate 420 and a second surface 411d facing in a direction opposite to the first surface 411c. For example, the first surface 411c may be a surface of the first region 411 facing the second plate 420. For example, the first surface 411c may be a surface of the first region 411 facing the space covered by the first plate 410 and the second plate 420. For example, the first surface 411c may be a surface facing at least a portion of the wick structure 430 disposed between the first plate 410 and the second plate 420. For example, the first surface 411c may be a surface of the first region 411 that is in contact with the wick structure 430. For example, the second surface 411d may be a surface of the first region 411 facing the electronic component 300. For example, the second surface 411d may be a surface of the first region 411 facing the outside of the vaper chamber 400. For example, the second surface 411d may be a surface of the first region 411 that forms at least a portion of the exterior of the vapor chamber 400. For example, at least a portion of the heat transferred from the electronic component 300 to the first region 411 may be transferred from the second surface 411d to the wick structure 430 facing the first surface 411c through the first surface 411c.

The vaper chamber 400 may require a structure in which a portion of the wick structure 430 in the vaper chamber 400 corresponding to the first region 411 substantially contacts the entire first region 411 and provides a space for a fluid in gaseous state in the vaper chamber 400, for efficient heat diffusion from the first region 411 of the first plate 410, which receives relatively more heat from the electronic component 300. The vapor chamber 400 may require a structure extending from the first plate 410 to the second plate 420 facing the first plate 410, in order for the portion corresponding to the second region 412 extending from the first region 411 of the wick structure 430 to provide a space for the fluid in the gaseous state. The wick structure 430 for increasing the diffusion of the heat transferred from the electronic component 300 to the vapor chamber 400 will be described later.

According to an embodiment, the wick structure 430 may include a first wick 440 and a second wick 450. The first wick 440 may include a first portion 441 covering the first surface 411c of the first region 411 facing the second plate 420 and a second portion 442 extending from the first portion 441 along the second region 412. The second wick 450 may be located on the second plate 420 and the second portion 442 of the first wick 440. The second wick 450 may extend between the second plate 420 and the first wick 440. The second wick 450 may be disposed between the second plate 420 and the second portion 442 of the first wick 440.

For example, the first wick 440 may be a layer of the wick structure 430 in contact with the first plate 410. For example, the first wick 440 may be attached to the first plate 410. For example, the first wick 440 may extend along the first plate 410. For example, the first wick 440 may be a layer of the wick structure 430 adjacent to the first plate 410. For example, the first wick 440 may receive at least a portion of the heat transferred from the electronic component 300 to the first plate 410. For example, the first wick 440 may be spaced apart from the second plate 420. For example, the first wick 440 may be faced away from the second plate 420.

For example, the first portion 441 of the first wick 440 may be attached on the first surface 411c facing the second plate 420 of the first region 411. For example, the first portion 441 may overlap the first region 411 of the first plate 410 when the first plate 410 is viewed from above (e.g., when viewed in the -z direction). For example, the first portion 441 may cover the heat dissipation portion 411a of the first plate 410 and the third region 411b surrounding the heat dissipation portion 411a, when the first surface 411c of the first plate 410 is viewed from above (e.g., when viewed from the +z direction). For example, the first portion 441 may have a size larger than the size of the heat dissipation portion 411a of the first plate 410 and/or the size of the electronic component 300 disposed above the heat dissipation portion 411a, when the first plate 410 is viewed from above (e.g., when viewed in the -z direction). The first wick 440 may increase the diffusion of the heat transferred from the electronic component 300 to the wick structure 430 through the first region 411, by including the first portion 441 covering the first surface 411c facing the second plate 420 of the first region 411.

For example, the second portion 442 of the first wick 440 may be disposed between the second region 412 of the first plate 410 and the second plate 420. For example, the second portion 442 may be attached to the second region 412 of the first plate 410. For example, the second region 412 of the first plate 410 may include a third surface 412a facing the second plate 420 and a fourth surface 412b opposite to the third surface 412a. The third surface 412a may extend from the first surface 411c of the first region 411. The fourth surface 412b may extend from the second surface 411d of the first region 411. The second portion 442 of the first wick 440 may be attached to the third surface 412a of the second region 412. For example, the second portion 442 may extend along the third surface 412a of the second region 412. For example, the second portion 442 may extend from the first portion 441 of the first wick 440 in a direction (e.g., the +y direction) in which the second region 412 of the first plate 410 extends. For example, the second portion 442 may have substantially the same thickness as the first portion 441, but is not limited thereto. For example, the second portion 442 may diffuse heat transferred from the first portion 441 to the second portion 442, by extending from the first portion 441.

For example, the second wick 450 may be disposed between the second plate 420 and the first wick 440. For example, the second wick 450 may be interposed between the second plate 420 and the second portion 442 of the first wick 440. For example, the second wick 450 may be attached to one surface of the second plate 420 facing the first plate 410. For example, the second wick 450 may be a layer of the wick structure 430 adjacent to the second plate 420. For example, the second wick 450 may extend along the second plate 420. For example, the second wick 450 may be spaced apart from the first plate 410. For example, the second wick 450 may be faced away from the second region 412 of the first plate 410. For example, the second wick 450 may overlap the second portion 442 of the first wick 440 when the wick structure 430 is viewed from above (e.g., when viewed from the -z direction). For example, the second wick 450 may support the second portion 442 of the first wick 440. For example, the second wick 450 may fill the gap between the second portion 442 of the first wick 440 and the second plate 420. The wick structure 430 may provide additional space for the fluid in the gaseous state within the vapor chamber 400, by including the second wick 450 filling the gap between the second portion 442 of the first wick 440 and the second plate 420 within the vapor chamber 400. In that way, the wick structure 430 provides structure that the first wick 440 covers the whole heating area on plates 410, 420, and outside the heating area the second wick 450 together with the rest of the first wick 440 provides a center filled wick structure between the plates 410, 420. Such a so called "the center filled wick structure" may provide a relatively thick vapor space in order to help to minimize the vapor pressure drop in the vapor chamber 400.

Although the wick structure 430 has been described as including the first wick 440 and the second wick 450, it is not limited thereto. The wick structure 430 within the vaper chamber 400 may include a layer (e.g., the first wick 440) including a portion (e.g., the first portion 441) attached to the first region 411 relatively adjacent to the electronic component 300, and a plurality of layers interposed between the second region 412 extending from the first region 411 and the second plate 420 facing the second region 412. The portion of the wick structure 430 attached to the first region 411 may increase the diffusion of heat transferred from the electronic component 300 to the wick structure 430 through the first region 411, by covering one surface (e.g., the first surface 411c) of the first region 411. The plurality of layers interposed between the second region 412 and the second plate 420 may provide the space for the fluid in the gaseous state for heat diffusion within the vaper chamber 400, by including a structure filling the space between the second region 412 and the second plate 420.

According to an embodiment, the length d2 of the second region 412 of the first plate 410 may be greater than the length d1 of the first region 411. Since the length d2 of the second region 412 is greater than the length d1 of the first region 411, the second region 412 may provide the additional space for the diffusion of the heat transferred from the electronic component 300, to the second region 412 and the second portion 442 attached to the second region 412, through the first region 411.

According to an embodiment, the width w1 (e.g., a length in the x-axis direction) of the first portion 441 of the first wick 440 may be greater than the width w2 (e.g., the length in the x-axis direction) of the second portion 442 of the first wick 440. For example, the width (e.g., the length in the x-axis direction) of the first region 411 to which the first portion 441 is attached may be greater than the width (e.g., the length in the x-axis direction) of the second region 412 to which the second portion 442 is attached. As the width w1 of the first portion 441 is greater than the width w2 of the second portion 442, the wick structure 430 may increase the area of the first portion 441 of the wick structure 430, which receives a relatively large amount of heat from the electronic component 300.

According to an embodiment, the first wick 440 may include at least one of a mesh wick and a powder wick. The second wick 450 may include at least one of the mesh wick, the powder wick, and a fiber wick. As the first wick 440 includes at least one of the mesh wick and the powder wick, and the second wick 450 includes at least one of the mesh wick, the powder wick, and the fiber wick, the wick structure 430 may increase the diffusion of the heat transferred from the electronic component 300 to the wick structure 430.

According to an embodiment, in case that the second wick 450 includes at least one of the powder wick and the fiber wick, the thickness of the second wick 450 may be adjusted for the space within the vaper chamber 400 for the first wick 440. According to an embodiment, in case that the second wick 450 includes the mesh wick, the second wick 450 may adjust the thickness of the second wick 450 by including a plurality of mesh wicks stacked for the space within the vaper chamber 400 for the first wick 440.

According to the above-described embodiment, the vaper chamber 400 of the electronic device 101 may increase the diffusion of the heat transferred from the electronic component 300 to the vaper chamber 400 by including the wick structure 430 including the first wick 440 and the second wick 450. The first wick 440 may increase the diffusion of the heat transferred from the electronic component 300 to the wick structure 430 through the first plate 410, by including the first portion 441 covering the first surface 411c of the first plate 410. The wick structure 430 may provide the space for the fluid in the gaseous state for diffusing the heat within the vapor chamber, by including the second wick 450 filling the gap between the second portion 442 of the first wick 440 and the second plate 420.

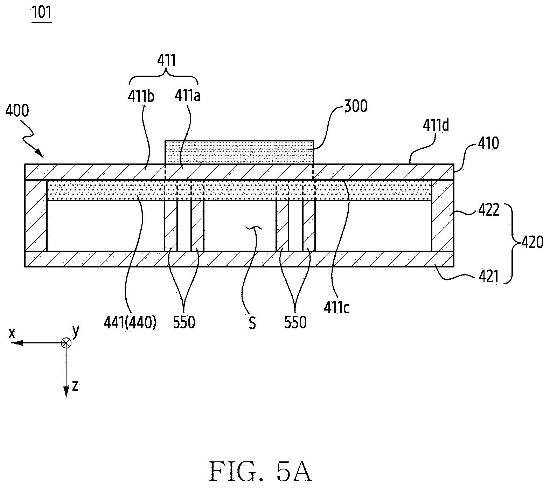

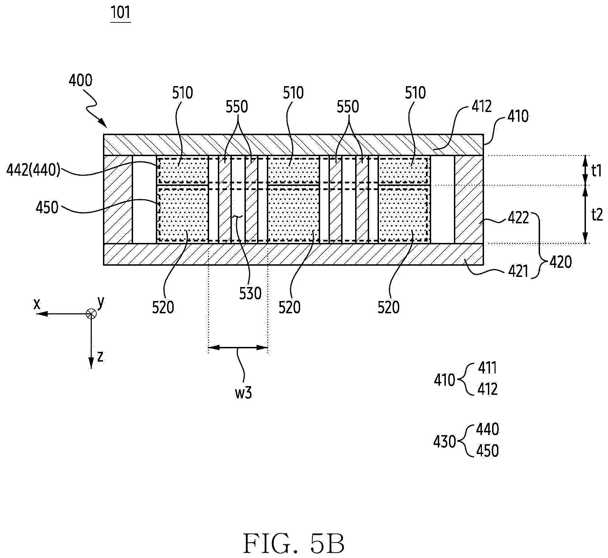

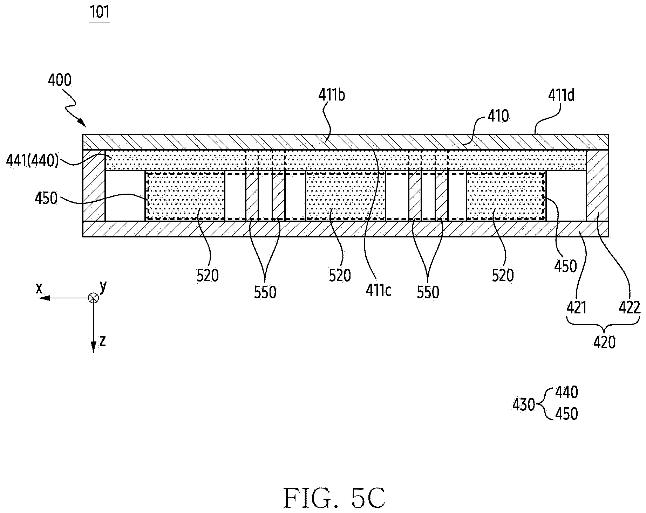

FIG. 5A is a cross-sectional view of an exemplary vaper chamber cut along line A-A' of FIG. 4B. FIG. 5B is a cross-sectional view of an exemplary vaper chamber cut along line B-B' of FIG. 4B. FIG. 5C is a cross-sectional view of an exemplary vaper chamber cut along line C-C' of FIG. 4B.

Referring to FIGS. 5A, 5B, and 5C, an electronic device 101 may include an electronic component 300 and a vapor chamber 400 configured to receive at least a portion of the heat emitted from the electronic component 300. The vaper chamber 400 may include a first plate 410, a second plate 420 supporting the first plate 410, and a wick structure 430 between the first plate 410 and the second plate 420. The first plate 410 may include a first region 411 including a heat dissipation portion 411a facing the electronic component 300, and a second region 412 connected to the first region 411. The wick structure 430 may include a first wick 440 including a first portion 441 covering the first surface 411c of the first region 411 facing the second plate 420 and a second portion 442 extending from the first portion 441 along the second region 412. The wick structure 430 may include a second wick 450 interposed between the second plate 420 and the second portion 442.

Hereinafter, overlapping descriptions of the configurations described in FIGS. 4A and 4B will be omitted.

According to an embodiment, the second plate 420 may include a base 421 and a side wall 422. The base 421 may face the first plate 410 and may be spaced apart from the first plate 410. The side wall 422 may seal a space between the first plate 410 and the second plate 420 by extending from the base 421 to the first plate 410.

For example, the base 421 may be faced away from the first plate 410. For example, the base 421 may support at least a portion of the second wick 450. For example, the base 421 may provide the wick structure 430 and a space for a fluid in the vaper chamber 400, by being spaced apart from the first plate 410. For example, the side wall 422 may be in contact with the base 421 and the first plate 410. For example, the side wall 422 may be disposed between the first plate 410 and the base 421. For example, the side wall 422 may surround the space between the first plate 410 and the base 421. For example, the side wall 422 may be disposed along the periphery of the first plate 410. For example, the side wall 422 may support the first plate 410 by being attached to the periphery of the first plate 410.

According to an embodiment, the vapor chamber 400 may further include a fluid in the space covered by the first plate 410 and the second plate 420 and in which the wick structure 430 is disposed. The wick structure 430 may be a structure for moving the fluid in liquid state. For example, the fluid within the vapor chamber 400 may be vaporized by heat transferred from the electronic component 300. For example, when the heat from the electronic component 300 is transferred to the wick structure 430 through the first plate 410, the fluid in the liquid state within the wick structure 430 may be vaporized. As the fluid vaporized from the wick structure 430 spreads into the space within the vapor chamber 400, the heat from the electronic component 300 may be dispersed. For example, the fluid in gaseous state may be cooled by releasing the heat from the fluid in the gaseous state to the outside of the vaper chamber 400 in the space between the second region 412 of the first plate 410 and the second plate 420. The fluid liquefied by cooling may be absorbed by the second portion 442 of the wick structure 430 and/or the second wick 450. The fluid may be, for example, water, but is not limited thereto. For example, the wick structure 430 may have a porous structure for absorbing the fluid within the vapor chamber 400, but is not limited thereto.

According to an embodiment, the second portion 442 of the first wick 440 may include first liquid flow paths 510 spaced apart from each other. The second wick 450 may include second liquid flow paths 520 in contact with each of the first liquid flow paths 510. The first liquid flow paths 510 and the second liquid flow paths 520 may be configured to move the fluid in the liquid state.

For example, the first liquid flow paths 510 may move the fluid in the liquid state between the second region 412 of the first plate 410 and the second plate 420 through the first wick 440. For example, the first liquid flow paths 510 may be formed of a plurality of bars extending from the first portion 441 of the first wick 440. For example, the first liquid flow paths 510 may be referred to as a plurality of wick bodies disposed between the second region 412 of the first plate 410 and the second plate 420 and extending from the first portion 441 covering the first surface 411c among the first wick440, but are not limited thereto.

For example, the second wick 450 may move the fluid in the liquid state between the second region 412 of the first plate 410 and the second plate 420 through the second liquid flow paths 520. For example, the second liquid flow paths 520 may be formed of the plurality of bars extending along the second portion 442 of the first wick 440. For example, the second liquid flow paths 520 may be formed of a plurality of pillars interposed between the second plate 420 and the first wick 440 and spaced apart from each other. For example, the second liquid flow paths 520 may be referred to as a plurality of wick bodies in contact with each of the first liquid flow paths 510 of the second wick 450, but are not limited thereto. The second portion 442 may provide a structure for moving the fluid in the liquid state and a space for the fluid in the gaseous state, by including the first liquid flow paths 510 spaced apart from each other, and by including the second liquid flow paths 520 in which the second wick 450 interposed between the second portion 442 and the second plate 420 fills a space between the first liquid flow paths 510 and the second plate 420.

According to an embodiment, the first portion 441 may be spaced apart from the second plate 420. The wick structure 430 may further include gas flow paths 530 between the second region 412 and the second plate 420 formed by the first liquid flow paths 510 and the second liquid flow paths 520. The gas flow paths 530 may be configured to move the fluid in the gaseous state. For example, the gas flow paths 530 may be in contact with the first liquid flow paths 510 and the second liquid flow paths 520. For example, the gas flow paths 530 may move the fluid in the gaseous state within the vaper chamber 400 from the second portion 442 of the first wick 440 and the second wick 450 to a space between the first region 411 and the second plate 420 adjacent to the first portion 441 of the first wick 440. For example, the gas flow paths 530 may be referred to as a plurality of gaps within the wick structure 430 formed by the first liquid flow paths 510 and the second liquid flow paths 520 spaced apart from each other, but is not limited thereto. For example, the gas flow paths 530 formed by the first liquid flow paths 510 and the second liquid flow paths 520 may be referred to as a channel structure for moving the fluid within the wick structure 430, but are not limited thereto.

For example, the first plate 410 may receive heat from the electronic component 300 to the first region 411 including the heat dissipation portion 411a facing the electronic component 300. Since the first portion 441 of the first wick 440 is in contact with the first surface 411c facing the second plate 420 of the first region 411 and is spaced apart from the second plate 420, the fluid in the liquid state included in the first portion 441 may be moved to the space S between the first portion 441 and the second plate 420, by being vaporized by the heat. The first region 411 and/or the electronic component 300 may be cooled by the vaporized fluid.

For example, the fluid in the gaseous state moved from the first region 411 to the space S between the first region 411 and the second plate 420 may move to the space between the second region 412 of the first plate 410 and the second plate 420 through the gas flow paths 530. The fluid in the gaseous state may dissipate the heat to the outside of the vaper chamber 400 while moving through the gas flow paths 530. The fluid liquefied by dissipating the heat to the outside of the vaper chamber 400 may be absorbed through the first liquid flow paths 510 and/or the second liquid flow paths 520 disposed between the second region 412 and the second plate 420.

For example, the first liquid flow paths 510 and the second liquid flow paths 520 may move the fluid in the liquid state absorbed from the gas flow paths 530 within the space between the second region 412 and the second plate 420, to the first portion 441 in contact with the first region 411 of the first plate 410. The fluid in the liquid state moved from the first liquid flow paths 510 and the second liquid flow paths 520 to the first portion 441 may be moved to the space S between the first portion 441 and the second plate 420, by being vaporized by the heat transferred from the electronic component 300 to the first portion 441 through the first region 411. The wick structure 430 may provide the space for the fluid in the gaseous state and may increase diffusion of the heat transferred from the electronic component 300 to the vapor chamber 400, by covering the first surface 411c of the first region 411 and including the first portion 441 spaced apart from the second plate 420. The wick structure 430 may provide the space for the fluid in the gaseous state, by including the gas flow paths 530 between the second region 412 and the second plate 420 extending from the first region 411. The wick structure 430 may provide a movement path for moving the liquefied fluid to the first portion 441 attached to the first region 411, by including first liquid flow paths 510 extending from the first portion 441 and spaced apart from each other, and the second liquid flow paths 520 in contact with the first liquid flow paths 510, respectively.

According to an embodiment, the second plate 420 may include a plurality of pillars 550 (e.g., a plurality of pillars 470 of FIG. 4A) extending from the base 421 toward the first plate 410. For example, the plurality of pillars 550 may be disposed in the space between the first plate 410 and the second plate 420. For example, the plurality of pillars 550 may support the first plate 410. For example, the plurality of pillars 550 may be partially disposed between the first liquid flow paths 510. For example, the plurality of pillars 550 may be partially disposed between the second liquid flow paths 520. The second plate 420 may reduce the space for the fluid within the vapor chamber 400 from being reduced by external impact, by including the plurality of pillars 550.

According to an embodiment, the thickness t1 of the second portion 442 of the first wick 440 may be smaller than the thickness t2 of the second wick 450. For example, the thickness t1 of the second portion 442 may be smaller than the distance from each of the first liquid flow paths 510 of the second portion 442 to the base 421 of the second plate 420. As the thickness t1 of the second portion 442 of the first wick 440 is smaller than the thickness t2 of the second wick 450, the wick structure 430 may increase thermal conductivity of the fluid moving to the space S between the first portion 441 and the second plate 420 by being vaporized from the first portion 441 connected to the second portion 442, and may increase the diffusion of the heat transferred from the electronic component 300 to the vaper chamber 400.

According to an embodiment, the first liquid flow paths 510 of the second portion 442 may be spaced apart from each other at a designated interval w3. The second liquid flow paths 520 of the second wick 450 may be spaced apart from each other at the designated interval w3, and may be in contact with each of the first liquid flow paths 510. According to an embodiment, the gas flow paths 530 of the wick structure 430 may have a width corresponding to the designated interval w3. For example, the first liquid flow paths 510 may be spaced apart at the designated interval w3, and the second liquid flow paths 520 may overlap the first liquid flow paths 510, respectively, when the wick structure 430 is viewed from above (e.g., when viewed in the -z direction). For example, the second liquid flow paths 520 may fill the space between the first liquid flow paths 510 and the second plate 420 spaced apart from each other at the designated interval w3, by being spaced apart from each other at designated intervals w3. Since the gas flow paths 530 disposed between the first liquid flow paths 510 and the second liquid flow paths 520 are formed by the gap w3 in which the first liquid flow paths 510 are spaced apart and the gap w3 in which the second liquid flow paths 520 are spaced apart, the gas flow paths 530 may have a width corresponding to the designated interval w3.

For example, the second portion 442 of the first wick 440 including the first liquid flow paths 510 and the second wick 450 including the second liquid flow paths 520 may be spaced apart from the side wall 422 surrounding the space between the first plate 410 and the second plate 420. For example, the second portion 442 and the second wick 450 may be located in the center portion of the vapor chamber 400 when the vapor chamber 400 is viewed from above (e.g., when viewed from the -z direction). The structure of the first wick 440 and the second wick 450 extending from the first wick 440 to the second plate 420 may be referred to as a center-filled wick structure, but is not limited thereto. The second wick 450 may provide additional space for the fluid in the gaseous state by being spaced apart from the side wall 422 and extending from the first wick 440 to the second plate 420. The first wick 440 may include the first liquid flow paths 510 spaced apart from each other, and the second wick 450 may include the second liquid flow paths 520 spaced apart from each other, thereby providing the space for moving the fluid in the gaseous state.

According to an embodiment, the second region 412 may extend from the first region 411 in the first direction (e.g., the +y direction). The first liquid flow paths 510 of the second portion 442 may be arranged along a second direction (e.g., the +x direction) perpendicular to the first direction. For example, the first liquid flow paths 510 may extend from the first portion 441 along the second region 412 in the first direction (e.g., the +y direction). The first liquid flow paths 510 may be arranged in the second direction perpendicular to the first direction and corresponding to the width direction of the first plate 410. The second liquid flow paths 520 in contact with the first liquid flow paths 510, respectively, may be arranged in the second direction along the first liquid flow paths 510. The first liquid flow paths 510 spaced apart from each other may provide the additional space for movement of the fluid in the gaseous state, by being arranged in the second direction.

According to an embodiment, the second wick 450 may be in contact with at least a portion of the first portion 441. For example, when referring to FIG. 5C, a portion of the second wick 450 may be attached to the first portion 441. For example, the second liquid flow paths 520 of the second wick 450 may be in contact with the first portion 441, respectively. As the second wick 450 is in contact with the first portion 441, the wick structure 430 may be configured to transfer at least a portion of the heat transferred from the electronic component 300 to the first portion 441, to the second wick 450.

According to an embodiment, the first region 411 may include a third region 411b surrounding the heat dissipation portion 411a and in contact with the second region 412. The second wick 450 may at least partially overlap the third region 411b when the first plate 410 is viewed from above (e.g., when viewed from the -z direction). For example, at least a portion of the second wick 450 may face the third region 411b of the first plate 410. For example, since the first portion 441 of the first wick 440 covers the heat dissipation portion 411a and the third region 411b when the first surface 411c facing the second plate 420 of the first region 411 is viewed from above, the second wick 450 may be in contact with at least a portion of the first portion 441 covering the third region 411b. As at least a portion of the second wick 450 overlaps the third region 411b, the wick structure 430 may be configured to transfer at least a portion of the heat transferred from the electronic component 300 to the third region 411b to the second wick 450.

According to the above-described embodiment, the vapor chamber 400 of the electronic device 101 may increase the diffusion of the heat transferred from the electronic component 300 to the vapor chamber 400 by including the first wick 440 and the second wick 450. The first wick 440 may promote vaporization of the fluid included in the first portion 441 by the heat transferred from the first region 411 to the wick structure 430, by covering the first surface 411c of the first region 411 and including the first portion 441 spaced apart from the second plate 420. The first portion 441 may increase the diffusion of the heat transferred from the electronic component 300 to the vapor chamber 400 by promoting vaporization of the fluid. The second portion 442 extending from the first portion 441 and the second wick 450 in contact with the second portion 442 may increase the diffusion of the heat transferred from the electronic component 300 to the vapor chamber 400 by providing the additional space for the vaporized fluid.

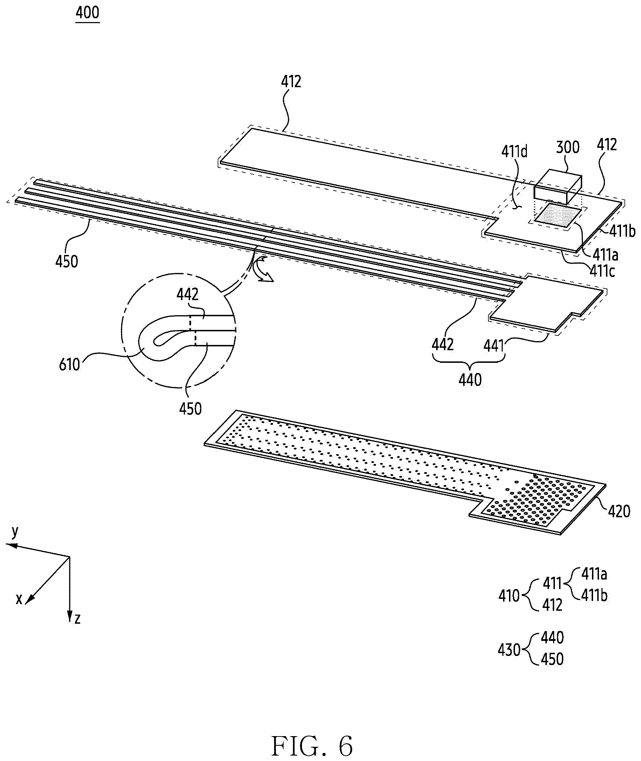

FIG. 6 is an exploded perspective view of a vaper chamber of an exemplary electronic device.

Referring to FIG. 6, an electronic device (e.g., an electronic device 101 of FIG. 1) may include an electronic component 300 and a vapor chamber 400 configured to receive at least a portion of the heat emitted from the electronic component 300. The vaper chamber 400 may include a first plate 410, a second plate 420 supporting the first plate 410, and a wick structure 430 between the first plate 410 and the second plate 420. The first plate 410 may include a first region 411 including a heat dissipation portion 411a facing the electronic component 300, and a second region 412 connected to the first region 411. The wick structure 430 may include a first wick 440 including a first portion 441 covering the first surface 411c of the first region 411 facing the second plate 420 and a second portion 442 extending from the first portion 441 along the second region 412. The wick structure 430 may include a second wick 450 interposed between the second plate 420 and the second portion 442.

According to an embodiment, the second wick 450 may extend from the first wick 440. The wick structure 430 may further include at least one banding portion 610 connecting the second wick 450 and the first wick 440. For example, the first wick 440 and the second wick 450 may be formed as one layer. As the second wick 450 is folding with respect to the first wick 440, the second wick 450 may be located between the second portion 442 of the first wick 440 and the second plate 420. However, it is not limited thereto. For example, when referring to FIG. 5C together, the second wick 450 may be folding with respect to the first wick 440 so as to contact at least a portion of the first portion 441 of the first wick 440. The second wick 450 may overlap at least a portion of the first portion 441 when the first portion 441 is viewed from above (e.g., when viewed in the -z direction), by being folded with respect to the first wick 440.

For example, at least one bending portion 610 may connect the first wick 440 and the second wick 450. For example, as the first wick 440 includes first flow paths (e.g., first liquid flow paths 510 of FIG. 5B), and the second wick 450 includes second liquid flow paths 520 which are in contact with the first liquid flow paths 510, respectively, the wick structure 430 may include a plurality of bending portions connecting the first liquid flow paths 510 and the second liquid flow paths 520. For example, the second wick 450 may be folded with respect to the first wick 440 based on at least one bending portion 610 from the state of forming one layer with the first wick 440. The second wick 450 may be folded so that the length of the second wick 450 corresponds to the length of the second portion 442 of the first wick 440. The second wick 450 of the wick structure 430 may simplify the manufacturing process of the layer structure of the wick structure 430, by being formed from the state of forming one layer with the first wick 440.

For example, the first wick 440 and the second wick 450 may be referred to as portions of an integrally formed wick structure 430 (or wick). The first liquid flow paths 510 included in the second portion 442 of the first wick 440 and the second liquid flow paths 520 included in the second wick 450 may be referred to as integrally formed liquid flow paths. However, it is not limited thereto.

According to the above-described embodiment, the wick structure 430 of the vapor chamber 400 may increase diffusion of heat transferred from the electronic component 300 to the vapor chamber 400 by including the first wick 440 and the second wick 450. The second wick 450 may simplify the manufacturing process of the wick structure 430, by being formed from the state of forming one layer with the first wick 440.

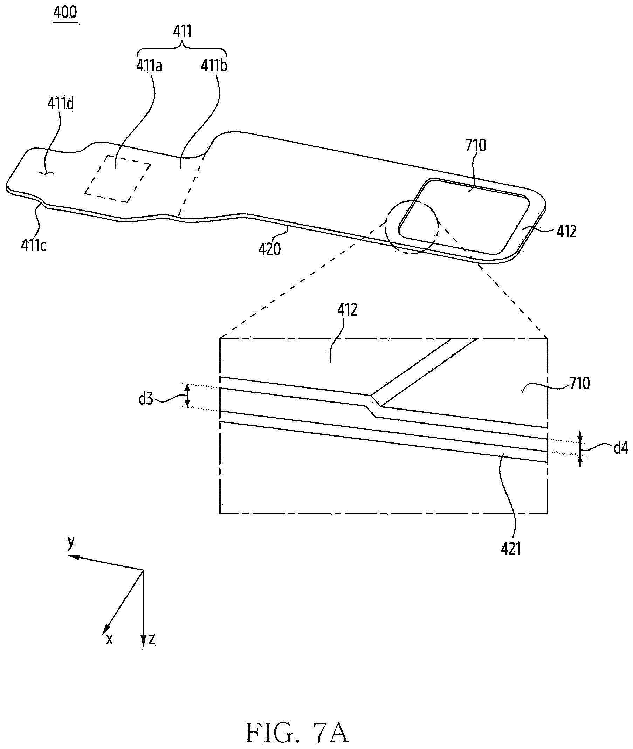

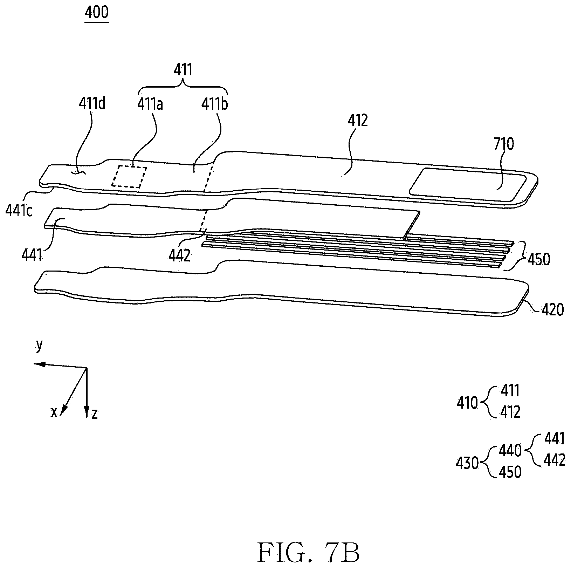

FIG. 7A illustrates a vaper chamber of an exemplary electronic device. FIG. 7B is an exploded perspective view of a vaper chamber of the exemplary electronic device of FIG. 7A.

Referring to FIGS. 7A and 7B, an electronic device (e.g., an electronic device 101 of FIG. 1) may include an electronic component (e.g., an electronic component 300 of FIG. 4A), and a vaper chamber 400 configured to receive at least a portion of heat emitted from the electronic component 300. The vaper chamber 400 may include a first plate 410, a second plate 420 supporting the first plate 410, and a wick structure 430 between the first plate 410 and the second plate 420. The first plate 410 may include a first region 411 including a heat dissipation portion 411a facing the electronic component 300, and a second region 412 connected to the first region 411. The wick structure 430 may include a first wick 440 including a first portion 441 covering the first surface 411c of the first region 411 facing the second plate 420 and a second portion 442 extending from the first portion 441 along the second region 412. The wick structure 430 may include a second wick 450 interposed between the second plate 420 and the second portion 442. According to an embodiment, the second plate 420 may include a base 421 and a side wall 422. The base 421 may face the first plate 410 and may be spaced apart from the first plate 410. The side wall 422 may seal the space between the first plate 410 and the second plate 420, by extending from the base 421 to the first plate 410.

According to an embodiment, the first plate 410 may further include a fourth region 710 extending from the second region 412 and dented toward the base 421 with respect to the second region 412. The distance d3 from the base 421 to the second region 412 may be greater than the distance d4 from the base 421 to the fourth region 710.

For example, the fourth region 710 may be surrounded by the second region 412. For example, another electronic component (e.g., a fingerprint recognition sensor) that is distinct from the electronic component 300 may be disposed on the fourth region 710. The vapor chamber 400 may provide additional space for the other electronic components, by including the fourth region 710 dented with respect to the second region 412.

According to an embodiment, the second wick 450 may extend from the base 421 to the fourth region 710. For example, the first portion 441 of the first wick 440 may be disposed between the first region 411 of the first plate 410 and the second plate 420. The second portion 442 and a portion of the second wick 450 extending from the first portion 441 of the first wick 440 may be disposed between the second region 412 of the first plate 410 and the second plate 420. The remaining portion of the second wick 450 may be disposed between the fourth region 710 that is extending from the second region 412 and dented with respect to the second region 412 and the second plate 420. The vaper chamber 400 may be configured to provide an additional space for at least one electronic component around the vaper chamber 400 and to dispose at least a portion of the wick structure 430 within a relatively thin space within the vaper chamber 400, by including the wick structure 430 including the first wick 440 and the second wick 450.

According to an embodiment, unlike the illustration in FIG. 7B, the second portion 442 of the first wick 440 among the first wick 440 and the second wick 450 may be interposed between the second region 412 and the base 421. The thickness of the second portion 442 may correspond to the distance d3 from the base 421 to the second region 412. The second wick 450 among the first wick 440 and the second wick 450 may be interposed between the fourth region 710 dented from the second region 412 toward the base 421 and the base 421. The thickness of the second wick 450 may correspond to the distance d4 from the base 421 to the fourth region 710. The wick structure 450 may be configured so that at least a portion of the wick structure 430 is disposed within a space having a relatively thin thickness, by disposing the second wick 450 having a relatively small thickness among the first wick 440 and the second wick 450 in a relatively thin portion of the space within the vaper chamber 400.

According to the above-described embodiment, the vaper chamber 400 may provide an additional space within the electronic device 101 for at least one electronic component around the vaper chamber 400, by including the fourth region 710 dented with respect to the second region 412. The vapor chamber 400 may provide additional space for at least one electronic component around the vapor chamber 400, by including the wick structure 430 including the first wick 440 and the second wick 450, and may increase a space in which the wick structure 430 for moving the fluid within the vaper chamber 400 is disposed, by being configured so that only the relatively thin second wick 450 among the first wick 440 and the second wick 450 of the wick structure 430 is disposed within the relatively thin space within the vapor chamber 400.

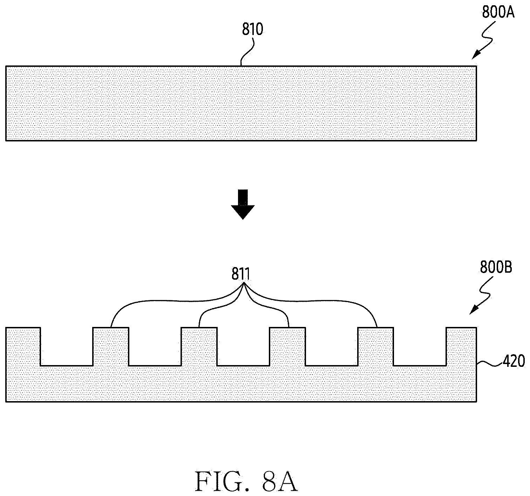

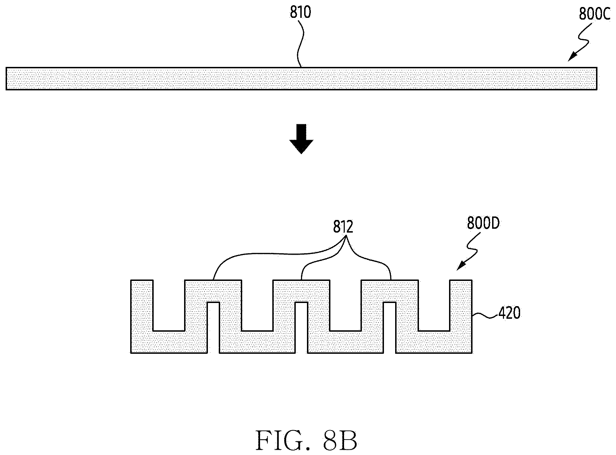

FIGS. 8A and 8B illustrate a manufacturing process of a second plate of an exemplary vaper chamber.

Referring to FIG. 8A, in step 800A, an original plate 810 for a second plate 420 may be prepared. The original plate 810 prepared in the step 800A may be relatively thick for etching. The original plate 810 may include metal, but is not limited thereto.

In step 800B, the second plate 420 may be formed through the etching of the original plate. First pillars 811 (e.g., a plurality of pillars 550 of FIG. 5B) may be formed through the etching process. The first pillars 811 may support a first plate (e.g., a first plate 410 of FIG. 4A) coupled to the second plate 420.

Referring to FIG. 8B, in step 800C, the original plate 810 for the second plate 420 may be prepared. The original plate 810 prepared in the step 800C may be relatively thin for pressing. The original plate 810 may include the metal, but is not limited thereto.

In step 800D, the second plate 420 may be formed through pressing. Second pillars 812 (e.g., the plurality of pillars 550 of FIG. 5B) may be formed through the pressing process. The second pillars 812 may support the first plate 410 coupled to the second plate 420.

According to the above-described embodiment, an electronic device (e.g., an electronic device 101 of FIG. 1) may comprise an electronic component (e.g., a processor 120 of FIG. 1 and an electronic component 300 of FIG. 4A). The electronic device may comprise a vapor chamber (e.g., a vaper chamber 400 of FIG. 4A) including a first plate (e.g., a first plate 410 of FIG. 4A), a second plate (e.g., a second plate 420 of FIG. 4A) supporting the first plate, and a wick structure (e.g., a wick structure 430 of FIG. 4A) between the first plate and the second plate. The first plate may include a first region (e.g., a first region 411 of FIG. 4A) on which the electronic component is disposed, and a second region (e.g., a second region 412 of FIG. 4A) connected to the first region. The wick structure may include a first wick (e.g., a first wick 440 of FIG. 4A) including a first portion (e.g., a first portion 441 of FIG. 4A) covering one surface (e.g., one surface 411c of FIG. 4A) of the first region facing the second plate, and a second portion (e.g., a second portion 412 of FIG. 4A) extending from the first portion along the second region. The wick structure may include a second wick (e.g., a second wick 450 of FIG. 4A) extending from the second plate to the second portion. According to the above-mentioned embodiment, the electronic device may reduce damage to the electronic device by heat generated from the electronic component, by including the vapor chamber. The vapor chamber may increase diffusion of heat transferred from the electronic component to the vapor chamber within the vapor chamber, by including the wick structure including the first wick and the second wick. The first portion may increase diffusion of heat transferred to the vapor chamber within the vapor chamber, by covering the first surface. The second wick may increase diffusion of heat transferred to the vapor chamber within the vapor chamber, by extending from the second plate to the second portion of the first wick. The above-mentioned embodiment may have various effects including the above-mentioned effect.

According to an embodiment, the second portion may include first flow paths (e.g., a first liquid flow paths 510 of FIG. 5B) spaced apart from each other. The second wick may include second flow paths (e.g., a second liquid flow paths 520 of FIG. 5B) contacting the first flow paths respectively. According to the above-mentioned embodiment, the wick structure may increase diffusion of heat transferred to the vapor chamber within the vapor chamber, by including the first flow paths and the second flow paths. The above-mentioned embodiment may have various effects including the above-mentioned effect.

According to an embodiment, the first portion may be spaced apart from the second plate. The wick structure may further include a third flow paths (e.g., gas flow paths 530 of FIG. 5B) between the second region and the second plate formed by the first flow paths and the second flow paths. According to the above-mentioned embodiment, the wick structure may provide a space for fluid in gaseous state within the vapor chamber by including the third flow paths. The above-mentioned embodiment may have various effects including the above-mentioned effect.

According to an embodiment, a width (e.g., w1 of FIG. 4A) of the first portion may be greater than a width (e.g., w2 of FIG. 4A) of the second portion. According to the above-mentioned embodiment, as the width of the first portion is greater than the width of the second portion, the first wick may increase diffusion of heat transferred to the vapor chamber within the vapor chamber. The above-mentioned embodiment may have various effects including the above-mentioned effect.

According to an embodiment, the first region further includes a heat dissipation portion (e.g., the heat dissipation portion 411a of FIG. 4A) facing the electronic component, and a third region (e.g., a third region 411b of FIG. 4A) surrounding the heat dissipation portion and contacting the second region. The second wick may at least partially overlap the third region when viewing the first plate from above. According to the above-mentioned embodiment, the second wick may increase diffusion of heat transferred to the vapor chamber within the vapor chamber, by at least partially overlapping the third region. The above-mentioned embodiment may have various effects including the above-mentioned effect.

According to an embodiment, the second wick may extend from the first wick. The wick structure may further include at least one bending portion (e.g., at least one bending portion 610 of FIG. 6) connecting the second wick and the first wick. According to the above-mentioned embodiment, the second wick may simplify the manufacturing process of the wick structure, by extending from the first wick. The above-mentioned embodiment may have various effects including the above-mentioned effect.

According to an embodiment, the second plate may include a base (e.g., a base 421 of FIG. 5A) facing the first plate and spaced apart from the first plate, and a side wall (e.g., a side wall 422 of FIG. 5A) extending from the base to the first plate so as to seal a space between the first plate and the second plate. The second wick may be in contact with the base and the second portion and may be spaced apart from the side wall. According to the above-mentioned embodiment, the second wick may increase diffusion of heat transferred to the vapor chamber within the vapor chamber, by being spaced apart from the side wall. The above-mentioned embodiment may have various effects including the above-mentioned effect.

According to an embodiment, the first plate may further include a fourth region (e.g., a fourth region 710 of FIG. 7A) extending from the second region and dented toward the base with respect to the second region. The second wick may extend from the base to the fourth region. According to the above-mentioned embodiment, the first plate may provide additional space in the electronic device for other electronic components that are distinct from the electronic component, by including the fourth region. The above-mentioned embodiment may have various effects including the above-mentioned effect.

According to an embodiment, a distance (e.g., d3 of FIG. 7A) between the base and the second region may be greater than a distance (e.g., d4 of FIG. 7A) between the base and the fourth region. According to the above-mentioned embodiment, the first plate may provide additional space in the electronic device for other electronic components that are distinct from the electronic component, by including the fourth region. The above-mentioned embodiment may have various effects including the above-mentioned effect.

According to an embodiment, the vapor chamber may further include a fluid in a space surrounded by the first plate and the second plate and in which the wick structure is disposed. The second portion may include first flow paths spaced apart from each other at a designated interval for moving the fluid in liquid state. The second wick may include the second flow paths spaced apart from each other at the designated interval (e.g., w3 of FIG. 5B), contacting the first flow paths respectively, and for moving the fluid in liquid state. According to the above-mentioned embodiment, the wick structure may increase diffusion of heat transferred to the vapor chamber within the vapor chamber, by including the first flow paths and the second flow paths. The above-mentioned embodiment may have various effects including the above-mentioned effect.

According to an embodiment, the wick structure may further include third flow paths formed by the first flow paths and the second flow paths, and each of the third flow paths has a width corresponding to the designated interval for moving the fluid in gaseous state. According to the above-mentioned embodiment, the wick structure may increase diffusion of heat transferred to the vapor chamber within the vapor chamber by including the third flow paths. The above-mentioned embodiment may have various effects including the above-mentioned effect.

According to an embodiment, the second region may extend from the first region in a first direction. The first flow paths may be arranged along a second direction perpendicular to the first direction. According to the above-mentioned embodiment, the wick structure may increase diffusion of heat transferred to the vapor chamber within the vapor chamber by including the first flow paths arranged along the second direction. The above-mentioned embodiment may have various effects including the above-mentioned effect.

According to an embodiment, the second wick may be in contact with at least a portion of the first portion. According to the above-mentioned embodiment, the second wick may increase diffusion of heat transferred to the vapor chamber within the vapor chamber by contacting at least a portion of the first portion. The above-mentioned embodiment may have various effects including the above-mentioned effect.

According to an embodiment, a thickness (e.g., t1 of FIG. 5B) of the first wick may be smaller than a thickness (e.g., t2 of FIG. 5B) of the second wick. According to the above-mentioned embodiment, as the thickness of the first wick is less than the thickness of the second wick, the wick structure may increase diffusion of heat transferred to the vapor chamber within the vapor chamber. The above-mentioned embodiment may have various effects including the above-mentioned effect.

According to an embodiment, the first wick may further include at least one of mesh wick, and powder wick. The second wick may include at least one of mesh wick, powder wick, and fiber wick. According to the above-mentioned embodiment, as the first wick includes at least one of the mesh wick and the powder wick and the second wick includes at least one of the mesh wick, the powder wick, and the fiber wick, the wick structure may increase diffusion of heat transferred to the vapor chamber within the vapor chamber. The above-mentioned embodiment may have various effects including the above-mentioned effect.

According to an embodiment, an electronic device may comprise an electronic component. The electronic device according to an embodiment may comprise a vapor chamber configured to receive at least a portion of heat emitted from the electronic component, and including a first plate, a second plate supporting the first plate, and a wick structure between the first plate and the second plate. The first plate may include a first region including a heat dissipation portion facing the electronic component, and a second region connected to the first region. The wick structure may include a first wick including a first portion covering one surface of the first region facing the second plate, and a second portion extending from the first portion along the second region and including first flow paths spaced apart from each other. The wick structure may include a second wick extending from the second plate to the second portion and including second flow paths contacting the first flow paths respectively. A width of the first portion may be greater than a width of the second portion. According to the above-mentioned embodiment, the electronic device may reduce damage to the electronic device by heat generated from the electronic component, by including the vapor chamber. The vapor chamber may increase diffusion of heat transferred from the electronic component to the vapor chamber within the vapor chamber, by including the wick structure including the first wick and the second wick. The first portion may increase diffusion of heat transferred to the vapor chamber within the vapor chamber, by covering the first surface. The second wick may increase diffusion of heat transferred to the vapor chamber within the vapor chamber, by extending from the second plate to the second portion of the first wick. The above-mentioned embodiment may have various effects including the above-mentioned effect.

According to an embodiment, the first portion may be spaced apart from the second plate. A According to the above-mentioned embodiment, the wick structure may provide a space for fluid in gaseous state within the vapor chamber by including the third flow paths. The above-mentioned embodiment may have various effects including the above-mentioned effect.

According to an embodiment, the second wick may extend from the first wick. The wick structure may further include at least one bending portion connecting the second wick and the first wick. According to the above-mentioned embodiment, the second wick may simplify the manufacturing process of the wick structure, by extending from the first wick. The above-mentioned embodiment may have various effects including the above-mentioned effect.

According to an embodiment, the second plate may include a base facing the first plate and spaced apart from the first plate, and a side wall extending from the base to the first plate so as to seal a space between the first plate and the second plate. The second wick may be in contact with the base and the second portion and may be spaced apart from the side wall. According to the above-mentioned embodiment, the second wick may increase diffusion of heat transferred to the vapor chamber within the vapor chamber, by being spaced apart from the side wall. The above-mentioned embodiment may have various effects including the above-mentioned effect.

According to an embodiment, the first plate may further include a fourth region extending from the second region and dented toward the space with respect to the second region. The second wick may extend from the base to the fourth region. According to the above-mentioned embodiment, the first plate may provide additional space in the electronic device for other electronic components that are distinct from the electronic component, by including the fourth region. The above-mentioned embodiment may have various effects including the above-mentioned effect.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
an electronic component; and
a vapor chamber including a first plate, a second plate supporting the first plate, and a wick structure between the first plate and the second plate; and,
wherein, the first plate includes:
a first region on which the electronic component is disposed; and
a second region connected to the first region; and,
wherein, the wick structure includes:
a first wick including a first portion covering one surface of the first region facing the second plate, and a second portion extending from the first portion along the second region; and
a second wick extending from the second plate to the second portion.

2. The electronic device of claim 1,
wherein, the second portion includes first flow paths spaced apart from each other, and
wherein, the second wick includes second flow paths contacting the first flow paths respectively.

3. The electronic device of claim 1 or 2,
wherein, the first portion spaced apart from the second plate, and
wherein, the wick structure further includes third flow paths between the second region and the second plate, wherein the third flow paths formed by the first flow paths and the second flow paths, respectively.

4. The electronic device of any one of claims 1 to 3,
Wherein, a width of the first portion is greater than a width of the second portion.

5. The electronic device of any one of claims 1 to 4,
wherein, the first region further includes a heat dissipation portion facing the electronic component, and a third region surrounding the heat dissipation portion and contacting the second region, and
wherein, the second wick at least partially overlaps the third region when viewing the first plate from above.

6. The electronic device of any one of claims 1 to 5,
wherein, the second wick extends from the first wick, and
wherein, the wick structure further includes at least one bending portion connecting the second wick and the first wick.

7. The electronic device of any one of claims 1 to 6,
wherein, the second plate includes:
a base facing the first plate and spaced apart from the first plate; and
a side wall extending from the base to the first plate so as to seal a space between the first plate and the second plate.

8. The electronic device of any one of claims 1 to 7,
wherein, the first plate further includes a fourth region extending from the second region and dented towards the base with respect to the second region, and
wherein, the second wick extends from the base to the fourth region.

9. The electronic device of any one of claims 1 to 8,
wherein, a distance between the base and the second region is greater than a distance between the base and the fourth region.

10. The electronic device of any one of claims 1 to 9,
wherein, the vapor chamber further includes a fluid in a space surrounded by the first plate and the second plate and in which the wick structure is disposed, and
wherein, the second portion includes first flow paths spaced apart from each other at a designated interval for moving the fluid in liquid state, and
wherein, the second wick includes second flow paths spaced apart from each other at the designated interval, contacting the first flow paths respectively, and for moving the fluid in liquid state.

11. The electronic device of any one of claims 1 to 10,
wherein, the wick structure further includes third flow paths formed by the first flow paths and the second flow paths, and wherein each of the third flow paths has a width corresponding to the designated interval for moving the fluid in gaseous state.

12. The electronic device of any one of claims 1 to 11,
wherein, the second region extends from the first region in a first direction, and
wherein, the first flow paths are arranged along a second direction perpendicular to the first direction.

13. The electronic device of any one of claims 1 to 12,
wherein, the second wick is in contact with at least a portion of the first portion.

14. The electronic device of any one of claims 1 to 13,
wherein, a thickness of the first wick is smaller than a thickness of the second wick.

15. The electronic device of any one of claims 1 to 14,
wherein, the first wick further includes at least one of mesh wick, and powder wick, and
wherein, second wick includes at least one of mesh wick, powder wick, and fiber wick.
